# EUROPEAN PATENT APPLICATION

(11) **EP 4 776 331 A1**
(43) Date of publication of application: **15.07.2026**
(21) Application number: 24865397.4
(22) Date of filing: 09.09.2024
(51) Int. Cl.: H01L 21/60, H01L 21/28, H10D 64/20

(54) **ELECTRONIC COMPONENT**

(30) Priority: 12.09.2023 JP 2023147521
(71) Applicant: TDK Corporation, Tokyo 103-6128 (JP)
(72) Inventor: ONO, Kenta, Tokyo 103-6128 (JP); SATO, Masato, Tokyo 103-6128 (JP); KITAO, Mitsuhiro, Tokyo 103-6128 (JP); TANAKA, Kosuke, Tokyo 103-6128 (JP)
(74) Representative: Epping - Hermann - Fischer
(86) International application number: PCT/JP2024/032172
(87) International publication number: WO 2025/057897

(57) **Abstract**

An electronic component includes a base material having a main surface, an insulating layer disposed on the main surface of the base material and having an opening, a conductive layer formed in the opening of the insulating layer, and a barrier layer covering the conductive layer, and a shape of at least an outer surface of the barrier layer has one mountain portion projecting upward.

## Description

### Technical Field

The present disclosure relates to an electronic component.

### Background Art

As an electronic component, one described in Patent Literature 1 is known. This electronic component includes a base material having a main surface, an insulating layer disposed on the main surface of the base material and having an opening, a conductive layer formed in the opening of the insulating layer, and a barrier layer covering the conductive layer.

### Citation List

### Patent Literature

Patent Literature 1: International Publication WO2022/244473

### Summary of Invention

### Technical Problem

A recess is formed on an upper surface of an electrode pad of the above-described electronic component. At a location of the recess, a seam may occur in the barrier layer. Further, when an etching liquid is used in an electronic component manufacturing process, a phenomenon occurs in which the etching liquid remains in the recess after the etching process. In this case, there is a possibility that the etching liquid corrodes the conductive layer by passing through the aforementioned seam. Therefore, it is required to suppress such corrosion and improve reliability of the electronic component.

An object of the present disclosure is to provide an electronic component capable of improving reliability.

### Solution to Problem

An electronic component according to the present disclosure includes a base material having a main surface, an insulating layer disposed on the main surface of the base material and having an opening, a conductive layer formed in the opening of the insulating layer, and a barrier layer covering the conductive layer, wherein a shape of at least an outer surface of the barrier layer has one mountain portion projecting upward.

In the electronic component according to the present disclosure, the shape of the outer surface of the barrier layer covering the conductive layer has one mountain portion projecting upward. According to such a shape, formation of a recess on the outer surface of the barrier layer can be suppressed. Therefore, it is possible to suppress accumulation of the etching liquid used in the etching process on the outer surface of the barrier layer. Therefore, even when the etching process is used, corrosion due to the etching liquid entering the conductive layer can be suppressed. From the above, the reliability of the electronic component can be improved.

The barrier layer may extend onto the insulating layer. In this case, it is possible to suppress corrosion of the conductive layer existing on the insulating layer by the etching liquid.

The electronic component may further have a thin film formed on the barrier layer. In this case, even if a defect such as a hole exists in the barrier layer, the thin film can cover the defect. Therefore, corrosion of the conductive layer by the etching liquid can be more reliably suppressed.

The barrier layer contains at least any one of Ni, Ta, Ti, W, Mo, Cr, Zn, In, Nb, Sn, and C. In this case, corrosion resistance of the barrier layer against the etching liquid can be improved. Therefore, it is possible to suppress corrosion of the conductive layer due to a defect caused by corrosion of the barrier layer.

A thickness of the barrier layer may be 100 nm or more. In this case, the barrier layer can sufficiently cover the conductive layer. Therefore, corrosion of the conductive layer against the etching liquid can be more reliably suppressed.

The insulating layer may contain at least one of silicon oxide, silicon nitride, silicon oxynitride, epoxy resin, and polyimide. In this case, corrosion resistance of the insulating layer itself against the etching liquid can be improved. As a result, it is possible to suppress corrosion of the conductive layer due to a defect caused by corrosion of the insulating layer.

The base material may contain GaN. A solution containing H₂O₂ is often used as the etching liquid. This H₂O₂ may oxidize GaN to form Ga₂O₃. Therefore, when GaN is used as the base material, if the conductive layer is corroded and H₂O₂ penetrates to the base material, Ga₂O₃ is formed between GaN and the conductive layer, and there is a possibility that it will not operate as a semiconductor. Therefore, the present disclosure can make the effect more remarkable when GaN is contained in the base material.

### Advantageous Effects of Invention

According to the present disclosure, it is possible to provide an electronic component capable of improving reliability.

### Brief Description of Drawings

FIG. 1 is a schematic cross-sectional view showing an electronic component according to an embodiment of the present disclosure.
FIG. 2 is a schematic cross-sectional view showing an electronic component according to a comparative example.
FIG. 3 is a schematic cross-sectional view showing an electronic component according to a modification.
FIG. 4 is a schematic cross-sectional view showing an electronic component according to a modification.
FIG. 5 is a schematic cross-sectional view showing an electronic component according to a modification.
FIG. 6 is a schematic cross-sectional view showing an electronic component according to a modification.

### Description of Embodiments

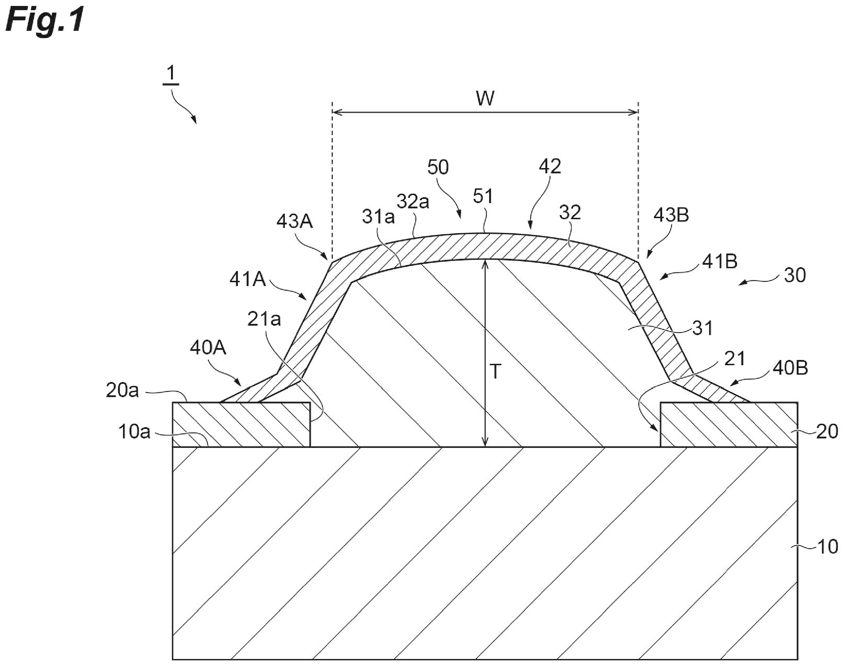

A configuration of an electronic component according to an embodiment will be described with reference to FIG. 1. An electronic component 1 according to the embodiment includes a base material 10, an insulating layer 20, and an electrode pad 30. The electronic component 1 is, as an example, a semiconductor element, and is, for example, an LED element or a semiconductor laser element.

The base material 10 is a flat plate-shaped member. The base material 10 has a flat main surface 10a. The base material 10 may contain GaN. In addition, the base material 10 may contain GaAs, GaP, AlGaInP, InGaN, Si, or the like.

The insulating layer 20 is disposed on the main surface 10a so as to cover the main surface 10a of the base material 10. The insulating layer 20 is a so-called passivation film. The insulating layer 20 has a flat main surface 20a. The insulating layer 20 is composed of an oxide or a nitride containing at least one kind of element of Si, Al, Zr, Mg, Ta, Ti, and Y, or a resin. For example, the insulating layer 20 may contain at least one of silicon oxide, silicon nitride, silicon oxynitride, epoxy resin, and polyimide. A thickness of the insulating layer 20 is not particularly limited, but may be 100 nm or more and may be 3000 nm or less.

An opening 21 is provided in the insulating layer 20. The opening 21 has an arbitrary shape (for example, a circular shape, a polygonal shape, etc.) when viewed from a direction orthogonal to the main surface 10a. The opening 21 of the insulating layer 20 has an inner peripheral surface 21a extending in a vertical direction between the main surface 10a of the base material 10 and the main surface 20a of the insulating layer 20. In the present embodiment, the inner peripheral surface 21a extends substantially perpendicularly to the main surface 10a.

The electrode pad 30 is composed of a metal material. The electrode pad 30 is a thick-film electrode provided in the vicinity of the opening 21 of the insulating layer 20 and extending in a normal direction of the main surface of the base material 10. The electrode pad 30 includes a conductive layer 31 and a barrier layer 32. The conductive layer 31 is a portion located on an upper side of the insulating layer 20. The electrode pad 30 has an arbitrary shape (for example, a circular shape, a polygonal shape, etc.) when viewed from the direction orthogonal to the main surface 10a.

The conductive layer 31 is formed in the opening 21 so as to cover the opening 21 of the insulating layer 20. The conductive layer 31 can be formed by, for example, sputtering of Cu. More specifically, the conductive layer 31 integrally covers an edge of the opening 21 in the main surface 20a of the insulating layer 20, the main surface 10a of the base material 10 exposed from the opening 21, and the inner peripheral surface 21a of the opening 21.

The barrier layer 32 is a layer covering the conductive layer 31. The barrier layer 32 covers the entire area of an outer surface 31a of the conductive layer 31. As described above, the conductive layer 31 covers the edge of the opening 21 of the insulating layer 20. Therefore, the barrier layer 32 also covers the edge of the opening 21 of the insulating layer 20. Therefore, the barrier layer 32 extends onto the insulating layer 20. The barrier layer 32 may contain at least any one of Ni, Ta, Ti, W, Mo, Cr, Zn, In, Nb, Sn, and C. The thickness of the barrier layer 32 may be 100 nm or more, and may be 300 nm or more. The thickness of the barrier layer 32 may be 3000 nm or less, and may be 1000 nm or less.

Next, a cross-sectional shape of the electrode pad 30 will be described. The electrode pad 30 has a shape rising upward from the base material 10. The electrode pad 30 has edge portions 40A and 40B, rising portions 41A and 41B, and a body portion 42. The edge portion 40 is a portion extending along the main surface 20a in the vicinity of the edge of the opening 21 of the main surface 20a of the insulating layer 20. The edge portion 40 is thinner than the body portion 42. The rising portion 41 is a portion rising upward from the edge portion 40. The body portion 42 is a portion formed thick at a central position of the electrode pad 30. A thickness T of the conductive layer 31 in the body portion 42 may be 100 nm or more and may be 5000 nm or less.

In the present embodiment, the outer surface 31a of the conductive layer 31 and the outer surface 32a of the barrier layer 32 have shapes having the same purport as each other, and are in a substantially parallel relationship. The outer surface of the electrode pad 30 corresponds to the outer surface 32a of the barrier layer 32 which is an outermost layer.

In a cross-sectional view, the electrode pad 30 has a pair of rising portions 41A and 41B and a pair of edge portions 40A and 40B on left and right sides of the body portion 42. The rising portions 41A and 41B may be regarded as locations where the outer surfaces 31a and 32a form an angle of 45° or more with respect to the main surface 10a. However, when the electrode pad 30 has a gentle curved shape as a whole, locations corresponding to the rising portions 41A and 41B may be omitted.

The outer surfaces 31a and 32a of the body portion 42 extend along a direction in which the main surface 10a extends, between an upper end of the rising portion 41A and an upper end of the rising portion 41B. Note that corner portions 43A and 43B are formed at locations where the rising portions 41A and 41B and the body portion 42 are connected. However, as shown in FIG. 1, the corner portions 43A and 43B do not need to be clearly formed, and it is sufficient that the rising portions 41A and 41B and the body portion 42 are connected. In the present embodiment, the outer surfaces 31a and 32a of the body portion 42 have a shape projecting upward from an end portion on an outer peripheral side toward an inner peripheral side. Thereby, the shape of the outer surface 32a of the barrier layer 32 has one mountain portion 50 projecting upward. The shape of the outer surface 32a of the barrier layer 32 has one mountain portion 50 projecting upward.

The outer surfaces 31a and 32a of the mountain portion 50 draw a circular arc curved so as to be convex upward between the corner portion 43A and the corner portion 43B. A surface of the mountain portion 50 is referred to as a curved surface 51. When the mountain portion 50 is drawn by a circular arc, a radius of curvature of the outermost outer surface 32a in the mountain portion 50 may be 4.5 µm or more. A dimension W in a lateral direction of the mountain portion 50 may be 2 µm or more and may be 10 µm or less. In the present embodiment, the dimension W in the lateral direction of the mountain portion 50 is a dimension in the lateral direction between the corner portion 43A and the corner portion 43B. Note that minute irregularities formed due to surface roughness or minute convex portions slightly protruding due to manufacturing errors or the like may be formed on the outer surface 32a. However, these minute convex portions do not correspond to the mountain portion in the present specification. Note that regarding the corner portions 43A and 43B, portions on the outer peripheral side (that is, the rising portions 41A and 41B) go downward as they go away from the corner portions 43A and 43B. However, portions on the inner peripheral side (that is, the body portion 42) do not go downward as they go away from the corner portions 43A and 43B. Therefore, the corner portions 43A and 43B do not correspond to the mountain portion in the present specification.

A method of forming the mountain portion 50 of the electronic component 1 is not particularly limited. For example, as a method of forming the conductive layer 31, a method of adjusting an opening size of an opening of a lift-off resist with respect to the opening 21 of the insulating layer 20 and performing lift-off after sputtering film formation may be adopted. Further, the conductive layer 31 may be formed by film formation by plating. The mountain portion 50 may be formed by these methods.

Further, a technique for forming the barrier layer 32 so as to extend to the insulating layer 20 is not particularly limited. For example, as a method of forming the barrier layer 32, a method of widening the opening size of the opening of the lift-off resist and performing lift-off after sputtering film formation may be adopted. At this time, by making the opening size wider than the conductive layer 31, the barrier layer 32 can be extended to the insulating layer 20. Further, the barrier layer 32 may be formed by film formation by plating.

Operations and effects of the electronic component 1 according to the present embodiment will be described.

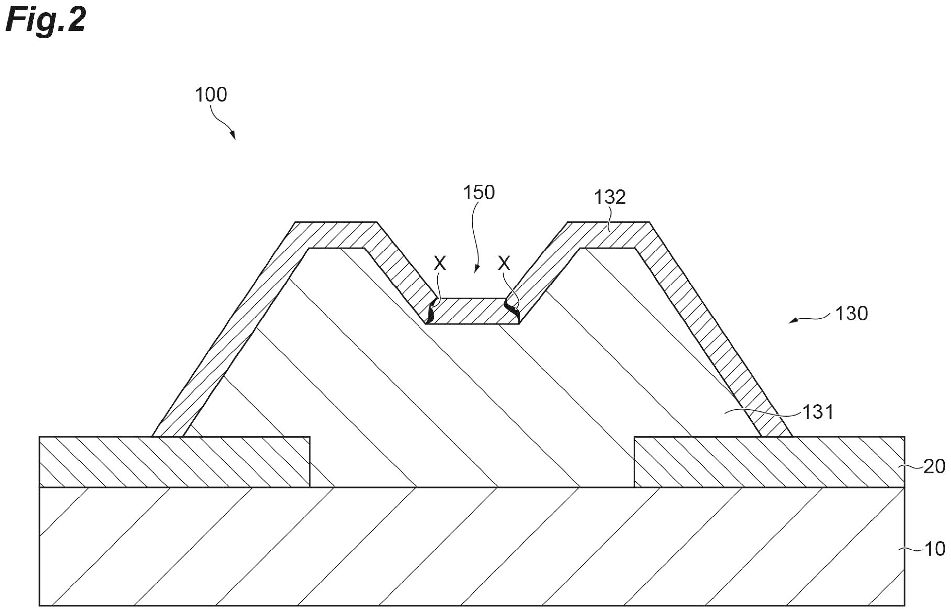

First, an electronic component 100 according to a comparative example will be described with reference to FIG. 2. As shown in FIG. 2, a recess 150 is formed on an upper surface of an electrode pad 130 of the electronic component 100 according to the comparative example. At a location of the recess 150, a seam X sometimes occurred in a barrier layer 132. Further, when an etching liquid is used in an electronic component manufacturing process, a phenomenon occurs in which the etching liquid remains in the recess 150 after the etching process. In this case, there is a possibility that the etching liquid corrodes a conductive layer 131 by passing through the aforementioned seam X.

On the other hand, in the electronic component 1 according to the present embodiment, the shape of the outer surface 32a of the barrier layer 32 covering the conductive layer 31 has one mountain portion 50 projecting upward. According to such a shape, formation of a recess on the outer surface 32a of the barrier layer 32 can be suppressed. Therefore, it is possible to suppress accumulation of the etching liquid used in the etching process on the outer surface 32a of the barrier layer 32. Therefore, even when the etching process is used, corrosion due to the etching liquid entering the conductive layer 31 can be suppressed. From the above, the reliability of the electronic component 1 can be improved.

The barrier layer 32 may extend onto the insulating layer 20. In this case, it is possible to suppress corrosion of the conductive layer 31 existing on the insulating layer 20 by the etching liquid.

The barrier layer 32 may contain at least any one of Ni, Ta, Ti, W, Mo, Cr, Zn, In, Nb, Sn, and C. In this case, corrosion resistance of the barrier layer 32 against the etching liquid can be improved. Therefore, it is possible to suppress corrosion of the conductive layer 31 due to a defect caused by corrosion of the barrier layer 32.

The thickness of the barrier layer 32 may be 100 nm or more. In this case, the barrier layer 32 can sufficiently cover the conductive layer 31. Therefore, corrosion of the conductive layer 31 against the etching liquid can be more reliably suppressed.

The insulating layer 20 may contain at least one of silicon oxide, silicon nitride, silicon oxynitride, epoxy resin, and polyimide. In this case, corrosion resistance of the insulating layer 20 itself against the etching liquid can be improved. As a result, it is possible to suppress corrosion of the conductive layer 31 due to a defect caused by corrosion of the insulating layer 20.

The base material 10 may contain GaN. A solution containing H₂O₂ is often used as the etching liquid. This H₂O₂ may oxidize GaN to form Ga₂O₃. Therefore, when GaN is used as the base material 10, if the conductive layer 31 is corroded and H₂O₂ penetrates to the base material 10, Ga₂O₃ is formed between GaN and the conductive layer 31, and there is a possibility that it will not operate as a semiconductor. Therefore, the structure of the electronic component 1 according to the embodiment can make the effect more remarkable when GaN is contained in the base material 10.

The present disclosure is not limited to the above-described embodiment.

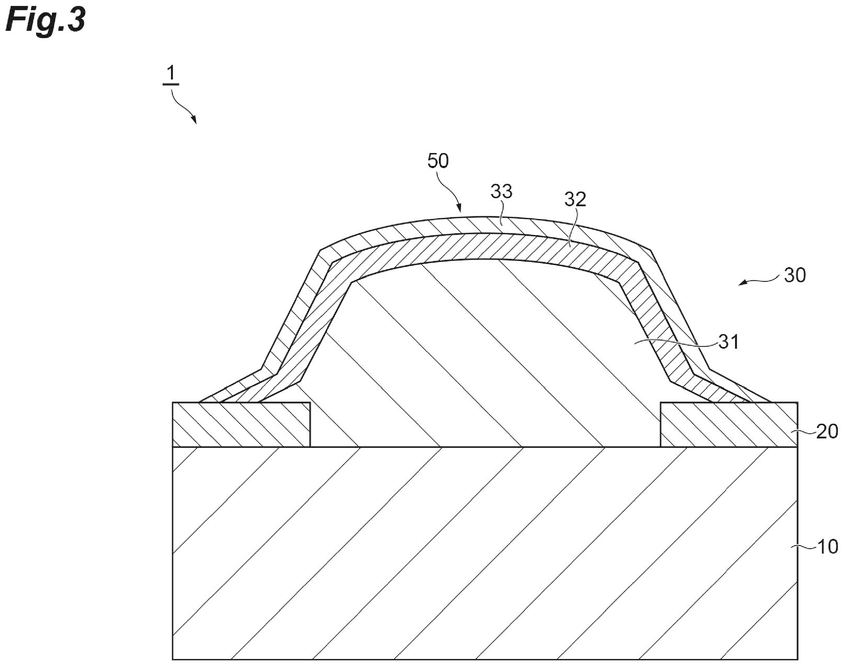

For example, a structure shown in FIG. 3 may be adopted. The electronic component 1 shown in FIG. 3 further has a thin film 33 formed on the barrier layer 32. The thin film 33 covers the barrier layer 32 over the whole. A material of the thin film 33 is not particularly limited, but for example, Au, Sn, Pd, or the like may be adopted. A thickness of the thin film 33 is not particularly limited, but may be 10 nm or more and 300 nm or less. In this case, even if a defect such as a hole exists in the barrier layer 32, the thin film 33 can cover the defect. Therefore, corrosion of the conductive layer 31 by the etching liquid can be more reliably suppressed.

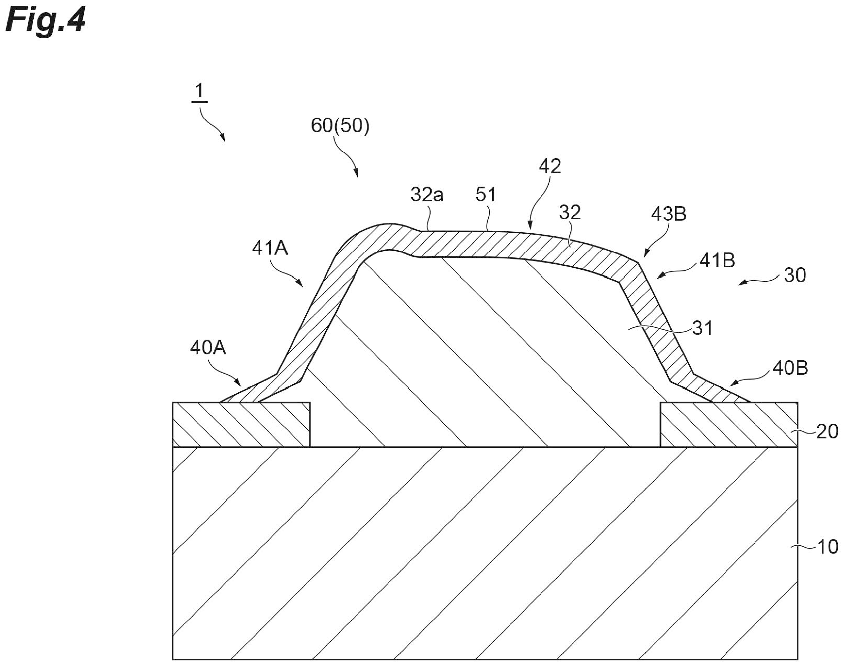

The shape and position of the mountain portion 50 are not limited to the above-described embodiment. For example, a structure shown in FIG. 4 may be adopted. In the electronic component 1 shown in FIG. 4, the mountain portion 50 is formed by a protruding portion 60 protruding upward from the aforementioned curved surface 51 in a part of the body portion 42. The protruding portion 60 is formed by extending the upper end of the rising portion 41A to a position higher than the other rising portion 41B and drawing a circular arc having a smaller radius of curvature than the circular arc of the curved surface 51. The curved surface 51 of the body portion 42 does not have a portion projecting upward other than the protruding portion 60. Therefore, the outer surface 32a of the barrier layer 32 has one mountain portion 50.

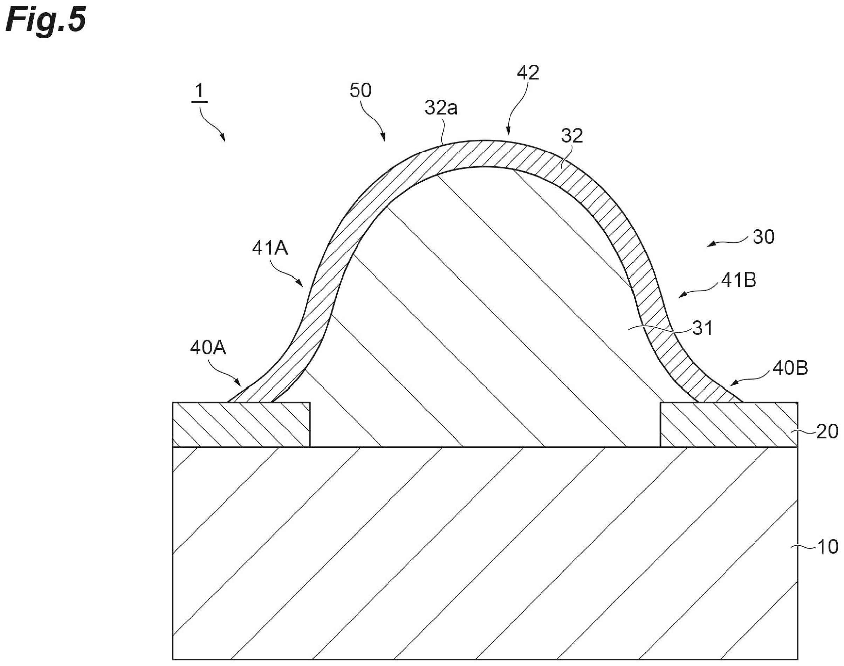

A structure shown in FIG. 5 may be adopted. In the electronic component 1 shown in FIG. 5, the entire body portion 42 is largely curved. Thereby, the corner portions 43A and 43B (see FIG. 1) are not formed between the rising portions 41A and 41B and the body portion 42, and the body portion 42 is formed so as to draw a continuous circular arc from the rising portions 41A and 41B. By the entire body portion 42 curving largely so as to project upward, the outer surface 32a of the barrier layer 32 has one mountain portion 50.

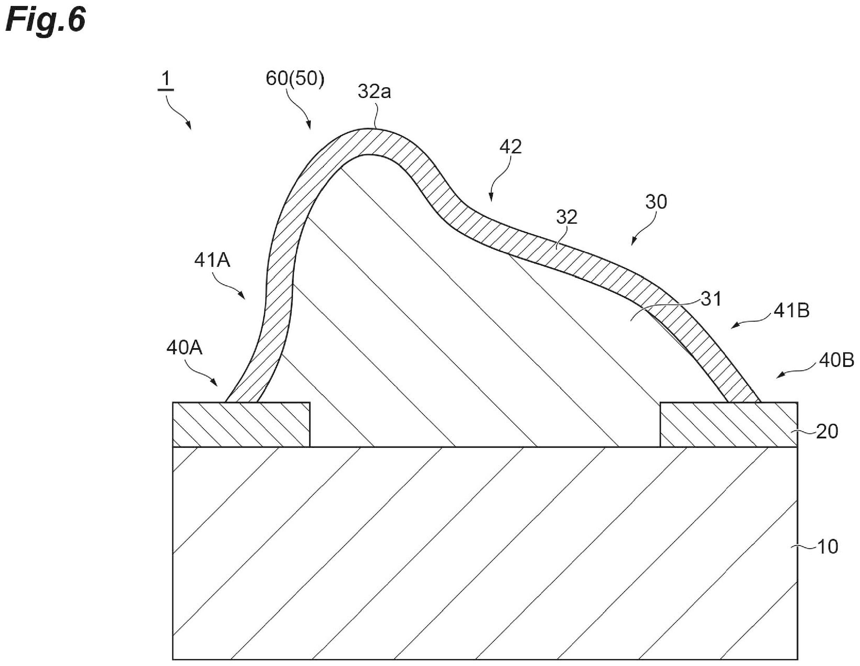

A structure shown in FIG. 6 may be adopted. The electronic component 1 shown in FIG. 6 is configured by curving the protruding portion 60 shown in FIG. 4 further largely and curving the rising portion 41B and the body portion 42 so as to eliminate the corner portion 43B. The body portion 42 does not have a portion projecting upward other than the protruding portion 60. Therefore, the outer surface 32a of the barrier layer 32 has one mountain portion 50.

Note that the shape of the barrier layer and the shape of the conductive layer do not necessarily have to match. For example, it is sufficient that the barrier layer has one mountain portion, and the conductive layer may have two or more mountain portions.

[Aspect 1] An electronic component comprising: a base material having a main surface; an insulating layer disposed on the main surface of the base material and having an opening; a conductive layer formed in the opening of the insulating layer; and a barrier layer covering the conductive layer, wherein a shape of at least an outer surface of the barrier layer has one mountain portion projecting upward.

[Aspect 2] The electronic component according to Aspect 1, wherein the barrier layer extends onto the insulating layer.

[Aspect 3] The electronic component according to Aspect 1 or 2, further comprising a thin film formed on the barrier layer.

[Aspect 4] The electronic component according to any one of Aspects 1 to 3, wherein the barrier layer contains at least any one of Ni, Ta, Ti, W, Mo, Cr, Zn, In, Nb, Sn, and C.

[Aspect 5] The electronic component according to any one of Aspects 1 to 4, wherein a thickness of the barrier layer is 100 nm or more.

[Aspect 6] The electronic component according to any one of Aspects 1 to 5, wherein the insulating layer contains at least one of silicon oxide, silicon nitride, silicon oxynitride, epoxy resin, and polyimide.

[Aspect 7] The electronic component according to any one of Aspects 1 to 6, wherein the base material contains GaN.

### Reference Signs List

- 1: electronic component
- 10: base material
- 20: insulating layer
- 31: conductive layer
- 32: barrier layer
- 50: mountain portion

## Claims

1. An electronic component comprising:
a base material having a main surface;
an insulating layer disposed on the main surface of the base material and having an opening;
a conductive layer formed in the opening of the insulating layer; and
a barrier layer covering the conductive layer,
wherein a shape of at least an outer surface of the barrier layer has one mountain portion projecting upward.

2. The electronic component according to Claim 1, wherein the barrier layer extends onto the insulating layer.

3. The electronic component according to Claim 1, further comprising a thin film formed on the barrier layer.

4. The electronic component according to Claim 1, wherein the barrier layer contains at least any one of Ni, Ta, Ti, W, Mo, Cr, Zn, In, Nb, Sn, and C.

5. The electronic component according to Claim 1, wherein a thickness of the barrier layer is 100 nm or more.

6. The electronic component according to Claim 1, wherein the insulating layer contains at least one of silicon oxide, silicon nitride, silicon oxynitride, epoxy resin, and polyimide.

7. The electronic component according to Claim 1, wherein the base material contains GaN.
